# FASCICULE DE BREVET EUROPEEN

(11) **EP 2 979 523 B1**
(45) Date de publication et mention de la délivrance du brevet: **14.07.2021**
(21) Numéro de dépôt: 14714204.6
(22) Date de dépôt: 21.03.2014
(51) Int. Cl.: H05K 1/02, F24H 3/04, F24H 9/20

(54) **MODULE DE COMMANDE D'UN APPAREIL ÉLECTRIQUE**
STEUERMODUL FÜR EINE ELEKTRISCHE ANWENDUNG
CONTROL MODULE FOR AN ELECTRIC APPLIANCE

(30) Priorité: 26.03.2013 FR 1352738
(43) Date de publication de la demande: 03.02.2016
(73) Titulaire: Valeo Systemes Thermiques, 78320 Le Mesnil-Saint-Denis (FR)
(72) Inventeur: PUZENAT, Bertrand, 78180 Montigny-le-Bretonneux (FR); ELBHAR, Thierry, 78610 Les Bréviaires (FR); AUDOYE, Jean-Baptiste, 75014 Paris (FR); RENARD, Alain, 78490 Gambaiseuil (FR)
(74) Mandataire: Tran, Chi-Hai
(86) Numéro de dépôt international: PCT/EP2014/055700
(87) Numéro de publication internationale: WO 2014/154581

(56) Documents cités:
- EP-A1- 0 727 928
- EP-A1- 2 330 865
- DE-A1-102006 009 812
- JP-A- S5 927 556
- JP-A- H10 256 677
- US-A1- 2007 057 742
- US-A1- 2010 290 183
- US-B1- 6 320 748

## Description

La présente invention concerne un module de commande d'un appareil électrique, ainsi qu'un dispositif de chauffage, notamment pour véhicule automobile, comportant un tel module de commande.

L'invention s'applique notamment au domaine technique des dispositifs de chauffage électriques additionnels pour véhicules automobiles. De tels dispositifs de chauffage sont notamment utilisés dans les premières minutes de démarrage du véhicule automobile, lorsque le moteur n'est pas suffisamment chaud pour assurer l'apport d'air chaud dans l'habitacle du véhicule. Ce temps de chauffe est par exemple compris entre 15 et 20 minutes pour un moteur de type Diesel.

Un tel dispositif de chauffage additionnel comporte en général un cadre support sur lequel sont montés des modules de chauffage parallèles agencés de façon à être traversés par un flux d'air à chauffer.

Chaque module de chauffage comporte deux électrodes entre lesquelles sont placés des éléments résistifs de type à coefficient de température positif. Deux dissipateurs thermiques opposés sont fixés sur les électrodes, de façon à augmenter la surface d'échange avec le flux d'air à chauffer. Les dissipateurs thermiques sont par exemple formés de rubans métalliques plissés ou ondulés.

Chaque module de chauffage comporte ainsi une borne positive reliée électriquement à la borne positive d'une batterie, et une borne négative reliée électriquement à la borne négative ou masse de la batterie par l'intermédiaire d'un transistor de puissance, tel qu'un transistor à effet de champ à grille métal-oxyde, également appelé MOSFET.

Plus particulièrement, chaque MOSFET est soudé sur une carte de circuit imprimé d'un module de commande, également appelé driver. Le module de commande est monté dans un boîtier fixé au cadre support.

Chaque MOSFET comporte une première borne appelée drain et reliée à la borne négative du module de chauffage correspondant, une deuxième borne appelée source et reliée à la borne négative ou masse de la batterie, et une troisième borne appelée grille servant à l'entrée d'un signal de contrôle permettant de commander l'ouverture et la fermeture du MOSFET.

Les différentes liaisons électriques peuvent être notamment assurées par des barreaux conducteurs liés mécaniquement entre eux par une garniture électriquement isolante fixée sur la carte de circuit imprimé.

Un tel dispositif de chauffage est notamment connu du document FR 2 954 606, au nom de la Demanderesse.

Le document US2007/057742 A1 décrit un module de commande d'un appareil électrique.

Lorsqu'un MOSFET est ouvert, aucun courant ne circule au travers des éléments résistifs correspondants. A l'inverse, lorsque le MOSFET est fermé, un courant passe dans les éléments résistifs de façon à provoquer le chauffage des électrodes et des dissipateurs thermiques.

Lorsqu'un MOSFET est fermé, c'est-à-dire lorsqu'il est à l'état passant, il a une résistance Rdson dont la valeur est par exemple de l'ordre de 4 mΩ. Le courant passant dans le MOSFET et les éléments résistifs étant relativement important, une quantité de chaleur comprise par exemple entre 2 W et 3 W est dissipée par le MOSFET, en fonctionnement normal.

Il existe également un risque très faible que le MOSFET soit endommagé en fonctionnement. Dans la majeure partie des cas, cet endommagement se traduit par un état de court-circuit impédant entre le drain et la source. En d'autres termes, le MOSFET se comporte comme si une impédance interne au MOSFET était montée en parallèle entre le drain et la source. Cette impédance a par exemple une valeur de l'ordre 40mΩ. La chaleur dissipée alors par le MOSFET est par exemple de l'ordre de 30 W.

Cette chaleur peut, à terme, entraîner une dégradation progressive du matériau de la carte de circuit imprimé, cette dégradation transformant ce matériau habituellement isolant en un matériau relativement conducteur.

Si une telle dégradation s'étend entre le drain et la source, plus particulièrement entre les pistes conductrices auxquelles sont reliées électriquement le drain et la source, le matériau dégradé de la carte de circuit imprimé agit comme une résistance. Parallèlement, le MOSFET finit par s'ouvrir complètement de sorte que la borne négative de l'élément chauffant est reliée à la borne négative ou masse de la batterie par l'intermédiaire de la résistance formée par le matériau dégradé de la carte de circuit imprimé. Dans ce cas, cette résistance est par exemple de l'ordre de 10 Ω. La chaleur dissipée par cette résistance est alors de l'ordre de 10 à 15 W.

Compte tenu de la quantité importante de chaleur à dissiper dans ce cas, il existe un risque que cette chaleur génère un départ de feu ou de la fumée au niveau de la carte de circuit imprimé et/ou des éléments environnants.

L'invention a notamment pour but d'apporter une solution simple, efficace et économique à ce problème.

A cet effet, elle propose un module de commande d'un appareil électrique comportant une carte de circuit imprimé, sur laquelle sont montés des composants électriques et électroniques et au moins un transistor de puissance, par exemple un transistor à effet de champ à grille métal-oxyde, fixé sur une première zone de la carte de circuit imprimé et comportant une première borne appelée drain, reliée à une première piste électriquement conductrice de ladite première zone, une deuxième borne appelée source et reliée à une deuxième piste électriquement conductrice d'une seconde zone de la carte de circuit imprimé et une troisième borne appelée grille, caractérisé en ce que la carte de circuit imprimé comporte au moins une ouverture formant une discontinuité de matière, au moins partielle, entre les première et seconde zones de la carte de circuit imprimé, ladite ouverture étant située entre les première et deuxième pistes conductrices.

De cette manière, en cas d'endommagement du transistor de puissance, même si le matériau de la première zone de la carte de circuit imprimé est dégradé, l'ouverture crée une discontinuité de matière entre les première et seconde zones de la carte de circuit imprimé et entre les première et deuxième pistes conductrices associées.

Dans le cas particulier du dispositif de chauffage précité, on interdit ainsi que, en cas de dégradation du MOSFET, la borne négative de l'élément chauffant soit reliée à la borne négative ou masse de la batterie, par l'intermédiaire d'une résistance formée par un matériau dégradé. On évite donc le risque de départ de feu ou le risque de génération de fumée associé.

Selon une forme de réalisation de l'invention, le transistor de puissance comporte une semelle formant le drain, en contact électrique avec la première piste, et une patte formant la source, reliée électriquement à la deuxième piste.

De préférence, l'ouverture est une fente entourant, au moins partiellement, la première zone de la carte de circuit imprimé.

Dans ce cas, la fente peut avoir une forme générale de U ou de L et comporter une base à partir de laquelle s'étend au moins une branche.

L'invention concerne également un dispositif de chauffage, notamment pour véhicule automobile, comprenant un module de commande du type précité. Le dispositif de chauffage comprend également au moins un module de chauffage comprenant une première borne reliée électriquement à une première borne d'une batterie, une deuxième borne reliée électriquement au drain du transistor de puissance, par l'intermédiaire d'un premier organe de liaison électrique, une deuxième borne de la batterie étant reliée électriquement à la source du transistor de puissance, par l'intermédiaire d'un deuxième organe de liaison électrique, la première borne du module de chauffage étant reliée électriquement à la première borne de la batterie par l'intermédiaire d'un troisième organe de liaison électrique, les trois organes de liaison étant liés mécaniquement les uns aux autres par l'intermédiaire d'une garniture électriquement isolante.

Les organes de liaison sont par exemple des barreaux conducteurs.

L'invention sera mieux comprise et d'autres détails, caractéristiques et avantages de l'invention apparaîtront à la lecture de la description suivante faite à titre d'exemple non limitatif en référence aux dessins annexés dans lesquels :
- la figure 1 est une vue schématique illustrant le montage d'un MOSFET entre la borne négative d'un élément chauffant et la masse d'une batterie, dans un cas de fonctionnement normal du MOSFET, conformément à l'art antérieur,
- la figure 2 est une vue correspondant à la figure 1, illustrant un état dégradé du MOSFET, à savoir un état de court-circuit impédant entre le drain et la source,
- la figure 3 est une vue correspondant à la figure 1, illustrant un état dégradé complètement ouvert du MOSFET et un état dégradé de la carte de circuit imprimé,
- la figure 4 est une vue de dessus d'une partie de la carte de circuit imprimé, illustrant le cas de la figure 3,
- la figure 5 est une vue de face d'un dispositif de chauffage selon l'invention,
- la figure 6 est une vue de dessus d'un module de commande selon l'invention, appartenant au dispositif de chauffage de la figure 4,
- la figure 7 est une vue de dessous d'une carte de circuit imprimé appartenant au module de commande selon l'invention,
- la figure 8 est une vue de dessus de la carte de circuit imprimé illustrant les différentes pistes électriquement conductrices,
- la figure 9 est une vue schématique du câblage électrique de puissance du dispositif de chauffage.

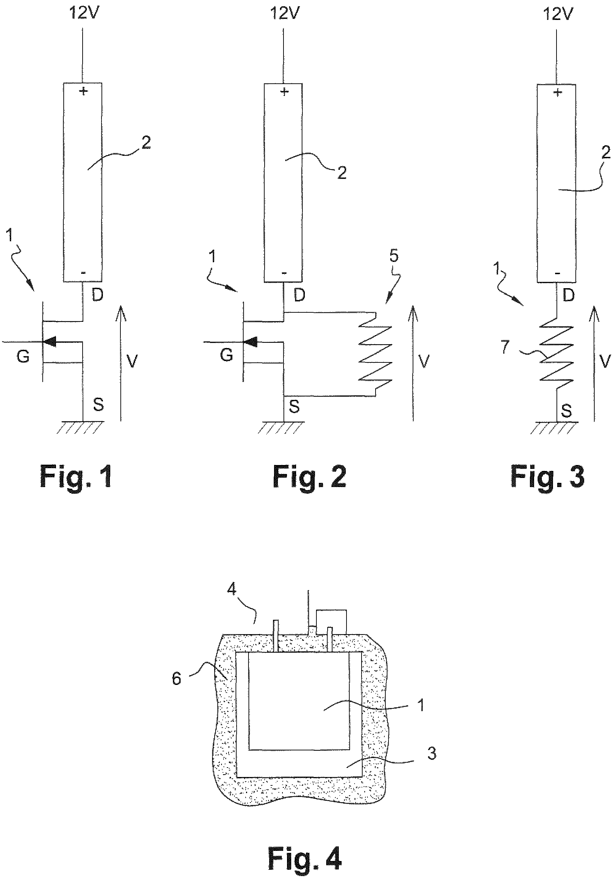

La figure 1 illustre un mode de fonctionnement normal d'un transistor de puissance 1 tel qu'un transistor à effet de champ à grille métal-oxyde, également appelé MOSFET, monté sur une carte de circuit imprimé. Un tel transistor 1 comporte classiquement une première borne D appelée drain, une deuxième borne S appelée source et une troisième borne G appelée grille et permettant de commander l'ouverture et la fermeture du MOSFET.

Le drain D est par exemple relié électriquement à la borne négative d'un module de chauffage 2, par l'intermédiaire notamment d'une première piste électriquement conductrice 3 (figure 4), la borne positive du module de chauffage 2 étant reliée à un potentiel formé par exemple par la borne positive d'une batterie. La source S est par exemple reliée à la borne négative ou masse de la batterie, par l'intermédiaire notamment d'une deuxième piste électriquement conductrice 4.

Ainsi, en fonctionnement normal, lorsque le MOSFET 1 est ouvert, aucun courant ne circule dans le module de chauffage 2. A l'inverse, lorsque le MOSFET 1 est fermé, un courant passe dans le module de chauffage 2.

Lorsque le MOSFET 1 est fermé, c'est-à-dire lorsqu'il est à l'état passant, il a une résistance Rdson dont la valeur est par exemple de l'ordre de 4 mΩ. Le courant passant dans le MOSFET 1 étant relativement important, une quantité de chaleur comprise par exemple entre 2 W et 3 W est dissipée par le MOSFET 1, en fonctionnement normal.

Il existe également un risque très faible que le MOSFET 1 soit endommagé en fonctionnement. Dans la majeure partie des cas, cet endommagement se traduit par un état de court-circuit impédant entre le drain D et la source S. Un tel état dégradé est illustré à la figure 2.

En d'autres termes, le MOSFET 1 se comporte comme si une impédance 5 (interne au MOSFET 1) était montée en parallèle entre le drain D et la source S. Cette impédance 5 a par exemple une valeur de l'ordre 40 mΩ. La chaleur dissipée alors par le MOSFET 1 est par exemple de l'ordre de 30 W.

Cette chaleur peut, à terme, entraîner une dégradation progressive du matériau de la carte de circuit imprimé (figure 4), cette dégradation transformant ce matériau habituellement isolant en un matériau relativement conducteur.

Si une telle dégradation s'étend entre le drain D et la source S, plus particulièrement entre les pistes conductrices 3, 4 auxquelles sont reliées électriquement le drain D et la source S, le matériau dégradé 6 de la carte de circuit imprimé agit comme une résistance (figure 3). Parallèlement, le MOSFET 1 finit par s'ouvrir complètement de sorte que la borne négative de l'élément chauffant 2 est reliée à la borne négative ou masse de la batterie par l'intermédiaire de la résistance 7 formée par le matériau dégradé 6 de la carte de circuit imprimé. Dans ce cas, cette résistance 7 est par exemple de l'ordre de 10 Ω. La chaleur dissipée par cette résistance 7 est alors de l'ordre de 10 à 15 W.

Compte tenu de la quantité importante de chaleur à dissiper dans ce cas, Il existe un risque que cette chaleur génère un départ de feu ou de la fumée au niveau de la carte de circuit imprimé et/ou des éléments environnants.

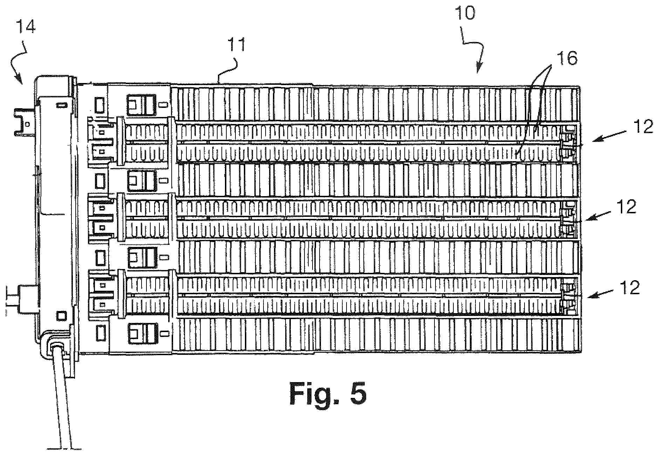

La figure 5 représente un dispositif de chauffage électrique additionnel 10 selon l'invention, destiné à équiper un véhicule automobile. Un tel dispositif de chauffage 10 est notamment utilisé dans les premières minutes d'utilisation du véhicule automobile, lorsque le moteur n'est pas suffisamment chaud pour assurer l'apport d'air chaud dans l'habitacle du véhicule.

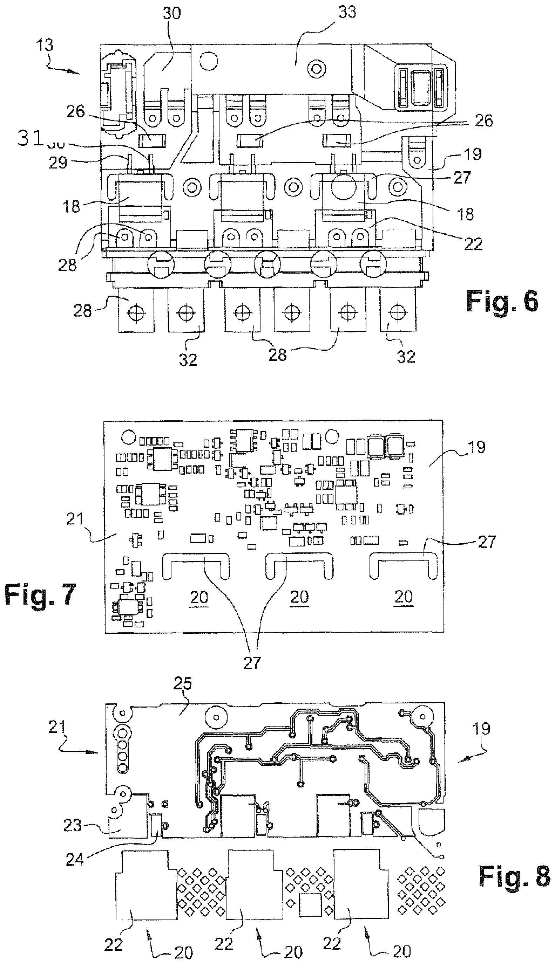

Ce dispositif 10 comporte un cadre support 11 de forme parallélépipédique sur lequel sont montés des modules de chauffage 12 parallèles et agencés de façon à être traversés par un flux d'air à chauffer. Les modules de chauffage 12 sont commandés à l'aide d'un module de commande 13 (figures 6) ou driver monté dans un boîtier 14 fixé au cadre support 11.

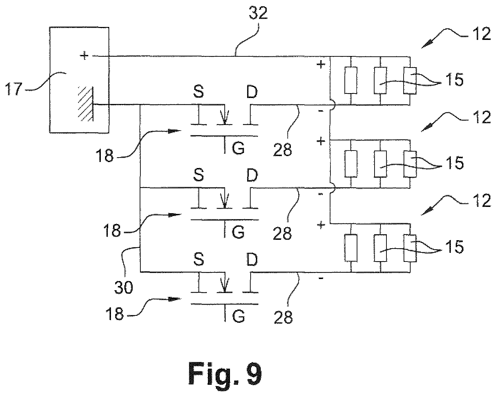

Chaque module de chauffage 12 comporte deux électrodes ou bornes référencées + et - à la figure 9, entre lesquelles sont placés des éléments résistifs 15 (figure 9) de type à coefficient de température positif (CTP). Deux dissipateurs thermiques opposés 16 sont fixés sur les électrodes, de façon à augmenter la surface d'échange avec le flux d'air à chauffer. Les dissipateurs thermiques 16 sont par exemple formés de rubans métalliques plissés ou ondulés.

Chaque module de chauffage 12 comporte ainsi une borne positive reliée électriquement à la borne positive d'une batterie 17, et une borne négative reliée électriquement à la borne négative de la batterie 17 par l'intermédiaire d'un transistor de puissance 18, tel qu'un transistor à effet de champ à grille métal-oxyde (MOSFET).

Le module de commande 13 comporte une carte de circuit imprimé 19 comprenant des premières zones 20 sur lesquelles sont montées les MOSFETs 18 et une seconde zone 21 sur laquelle sont notamment soudés ou montés différents composants électriques et électroniques (figures 7 et 8).

Chaque première zone 20 a une forme générale rectangulaire et comporte, sur sa face supérieure, une première piste 22 (figure 8) s'étendant sur la majeure partie de la première zone 20 et reliée au drain D du MOSFET 18 correspondant. Plus particulièrement, chaque MOSFET 18 comporte une semelle formant le drain D, en contact électrique avec la première piste 22 et soudée sur celle-ci.

La seconde zone 21 de la carte électronique 19 comporte une face supérieure sur laquelle sont formées respectivement trois deuxièmes pistes 23 électriquement conductrices et trois troisièmes pistes 24 électriquement conductrices, situées globalement en regard des premières pistes correspondantes 22, et une quatrième piste 25 électriquement conductrice reliée à la borne négative ou masse de la batterie 17. La quatrième piste 25 s'étend sur la majeure partie de la seconde zone et forme un plan de masse, comme cela est mieux décrit ci-après. Chaque deuxième piste 23 est reliée au plan de masse 25 par l'intermédiaire d'une résistance ou « shunt » 26 (figure 6) permettant d'effectuer une mesure de courant électrique. La valeur de ce « shunt » 26 est très faible, de l'ordre de quelques milliohms.

La carte de circuit imprimé 19 comporte trois fentes 27 situées respectivement entre chaque première zone 20 et la seconde zone 21 de la carte de circuit imprimé 19, chaque fente 27 formant une discontinuité de matière, au moins partielle, entre les première et seconde zones 20, 21 de la carte de circuit imprimé 19, ladite fente 27 étant située ou intercalée notamment entre les premières et deuxièmes pistes conductrices 22, 23.

Cette fente 27 a une forme générale de U (ou de L en fonction des applications et de la position de la fente) et comporte une base à partir de laquelle s'étendent deux branches.

Comme cela est mieux visible à la figure 9, le drain D de chaque MOSFET 18 est relié à la borne négative du module de chauffage correspondant 12, par l'intermédiaire de la première piste correspondante 22 et d'un premier barreau conducteur 28 comportant des terminaisons soudées sur la première piste 22.

La source S est formée par une première patte 29 du MOSFET 18 et est reliée à la borne négative ou masse de la batterie 17, par l'intermédiaire des deuxième et quatrième pistes 23, 25 de la carte de circuit imprimé 19, par l'intermédiaire du « shunt » correspondant 26 et par l'intermédiaire d'un second barreau conducteur 30 comportant des terminaisons soudées sur la quatrième piste 25. Dans la suite de la description, on négligera la présence du « shunt » 26, pour des raisons de simplification de l'exposé.

Enfin, la grille G du MOSFET 18 est formée par une patte 31 servant à l'entrée d'un signal de contrôle permettant de commander l'ouverture et la fermeture du MOSFET 18, ladite patte 31 étant soudée à la troisième piste correspondante 24 de la carte de circuit imprimé 19.

La liaison électrique entre les bornes positives de la batterie 17 et des modules chauffants 12 est assurée par un troisième barreau conducteur 32.

Les différents barreaux conducteurs 28, 30, 32, sont reliés mécaniquement les uns aux autres et isolés électriquement les uns par rapport aux autres par une garniture 33 surmoulée en matériau synthétique et jouant le rôle de support de façon à ce que lesdits barreaux conducteurs 28, 30, 32 et la garniture 33 forment un ensemble unitaire. La garniture 33 est fixée sur la carte de circuit imprimé 19.

Comme indiqué précédemment, lorsqu'un MOSFET 18 est ouvert, aucun courant ne circule au travers des éléments résistifs correspondants 15. A l'inverse, lorsque le MOSFET 18 est fermé, un courant passe dans les éléments résistifs 18 et entraîne ainsi la montée en température du module de chauffage correspondant 12.

Chaque MOSFET 18 peut être ouvert et fermé de façon cyclique, la température atteinte par chaque module de chauffage 12 étant alors fonction des durées d'ouverture et de fermeture du MOSFET 18.

La présente des fentes 27 permet d'éviter le cas représenté à la figure 3, dans laquelle une dégradation du matériau 6 de la carte de circuit imprimé 19 peut entraîner une forte montée en température.

Cette fente 27 empêche que le matériau dégradé 6 agisse à la manière d'une résistance 7 placée entre le potentiel du drain D (première piste 22) et celui de la source S (deuxième piste 23 ou quatrième piste 25). On rappelle que, compte tenu de l'influence négligeable du « shunt » 26, le potentiel des deuxième et quatrième pistes 23, 25 est sensiblement identique.

## Revendications

1. Module de commande (13) d'un appareil électrique (10) comportant une carte de circuit imprimé (19), sur laquelle sont montés des composants électriques et électroniques (26) et au moins un transistor de puissance (18), fixé sur une première zone (20) de la carte de circuit imprimé (19) et comportant une première borne (D) appelée drain, reliée à une première piste (22) électriquement conductrice de ladite première zone (20), une deuxième borne (S) appelée source et reliée à une deuxième piste (23) électriquement conductrice d'une seconde zone (21) de la carte de circuit imprimé (19) et une troisième borne (G) appelée grille, **caractérisé en ce que** la carte de circuit imprimé (19) comporte au moins une ouverture (27) formant une discontinuité de matière, au moins partielle, entre les première et seconde zones (20, 21) de la carte de circuit imprimé (19), ladite ouverture (27) étant située entre les première et deuxième pistes conductrices (22, 23).

2. Module de commande (13) selon la revendication 1, **caractérisé en ce que** le transistor de puissance (18) comporte une semelle formant le drain (D), en contact électrique avec la première piste (22), et une patte (29) formant la source (S), reliée électriquement à la deuxième piste (23).

3. Module de commande (13) selon la revendication 1 ou 2, **caractérisé en ce que** l'ouverture est une fente (27) entourant, au moins partiellement, la première zone (20) de la carte de circuit imprimé (19).

4. Module de commande (13) selon la revendication 3, caractérisé en en ce que la fente (27) a une forme générale de U ou de L et comporte une base à partir de laquelle s'étend au moins une branche.

5. Dispositif de chauffage (10), notamment pour véhicule automobile, comportant un module de commande (13) selon l'une des revendications 1 à 4.

6. Dispositif de chauffage selon la revendication 5, **caractérisé en ce qu'**il comprend au moins un module de chauffage (12) comprenant une première borne reliée électriquement à une première borne d'une batterie (17), une deuxième borne reliée électriquement au drain (D) du transistor de puissance (18), par l'intermédiaire d'un premier organe de liaison électrique (28), une deuxième borne de la batterie (17) étant reliée électriquement à la source (S) du transistor de puissance (18), par l'intermédiaire d'un deuxième organe de liaison électrique (30), la première borne du module de (12) étant reliée électriquement à la première borne de la batterie (17) par l'intermédiaire d'un troisième organe de liaison électrique (32), les trois organes de liaison (28, 30, 32) étant liés mécaniquement les uns aux autres par l'intermédiaire d'une garniture électriquement isolante (33).

## Patentansprüche

1. Steuermodul (13) einer elektrischen Vorrichtung (10) aufweisend eine Leiterplatte (19), auf der elektrische und elektronische Bauelemente (26) angebracht sind, und mindestens einen Leistungstransistor (18), der auf einem ersten Bereich (20) der Leiterplatte (19) befestigt ist und einen ersten Anschluss (D), Drain genannt, der mit einer ersten elektrisch leitenden Bahn (22) des ersten Bereichs (20) verbunden ist, einen zweiten Anschluss (S), der Source genannt wird und mit einer zweiten elektrisch leitenden Bahn (23) eines zweiten Bereichs (21) der Leiterplatte (19) verbunden ist, und einen dritten Anschluss (G), Gate genannt, aufweist, **dadurch gekennzeichnet, dass** die Leiterplatte (19) mindestens eine Öffnung (27) aufweist, die eine wenigstens teilweise Materialdiskontinuität zwischen dem ersten und zweiten Bereich (20, 21) der Leiterplatte (19) bildet, wobei sich die Öffnung (27) zwischen der ersten und zweiten Leiterbahn (22, 23) befindet.

2. Steuermodul (13) nach Anspruch 1, **dadurch gekennzeichnet, dass** der Leistungstransistor (18) einen Boden, der den Drain (D) bildet, der mit der ersten Bahn (22) in elektrischem Kontakt steht, und ein Bein (29), das die Source (S) bildet, das mit der zweiten Bahn (23) elektrisch verbunden ist, aufweist.

3. Steuermodul (13) nach Anspruch 1 oder 2, **dadurch gekennzeichnet, dass** die Öffnung ein Spalt (27) ist, der den ersten Bereich (20) der Leiterplatte (19) wenigstens teilweise umgibt.

4. Steuermodul (13) nach Anspruch 3, **dadurch gekennzeichnet, dass** der Spalt (27) eine allgemeine Form eines U oder L aufweist und eine Basis aufweist, von welcher sich wenigstens ein Schenkel erstreckt.

5. Heizvorrichtung (10), insbesondere für ein Kraftfahrzeug, aufweisend ein Steuermodul (13) nach einem der Ansprüche 1 bis 4.

6. Heizvorrichtung nach Anspruch 5, **dadurch gekennzeichnet, dass** sie mindestens ein Heizmodul (12) umfasst, das einen ersten Anschluss, der mit einem ersten Anschluss einer Batterie (17) elektrisch verbunden ist, einen zweiten Anschluss, der mittels eines ersten elektrischen Verbindungselements (28) mit dem Drain (D) des Leistungstransistors (18) elektrisch verbunden ist, umfasst, wobei ein zweiter Anschluss der Batterie (17) mittels eines zweiten elektrischen Verbindungselements (30) mit der Source (S) des Leistungstransistors (18) elektrisch verbunden ist, wobei der erste Anschluss des Moduls (12) mittels eines dritten elektrischen Verbindungselements (32) mit dem ersten Anschluss der Batterie (17) elektrisch verbunden ist, wobei die drei Verbindungselemente (28, 30, 32) mittels einer elektrisch isolierenden Einfassung (33) mechanisch miteinander verbunden sind.

## Claims

1. Control module (13) for an electric appliance (10) comprising a printed circuit board (19), on which are mounted electrical and electronic components (26) and at least one power transistor (18), fixed onto a first area (20) of the printed circuit board (19) and comprising a first terminal (D) called drain, linked to a first electrically conductive track (22) of said first area (20), a second terminal (S) called source and linked to a second electrically conductive track (23) of a second area (21) of the printed circuit board (19) and a third terminal (G) called gate, **characterized in that** the printed circuit board (19) comprises at least one opening (27) forming a discontinuity of material, at least partial, between the first and second areas (20, 21) of the printed circuit board (19), said opening (27) being situated between the first and second conductive tracks (22, 23).

2. Control module (13) according to Claim 1, **characterized in that** the power transistor (18) comprises a sole plate forming the drain (D), in electrical contact with the first track (22), and a pin (29) forming the source (S), linked electrically to the second track (23).

3. Control module (13) according to Claim 1 or 2, **characterized in that** the opening is a slit (27) encircling, at least partially, the first area (20) of the printed circuit board (19).

4. Control module (13) according to Claim 3, **characterized in that** the slit (27) is generally U- or L-shaped and comprises a base from which extends at least one branch.

5. Heating device (10), notably for a motor vehicle, comprising a control module (13) according to one of Claims 1 to 4.

6. Heating device according to Claim 5, **characterized in that** it comprises at least one heating module (12) comprising a first terminal linked electrically to a first terminal of a battery (17), a second terminal linked electrically to the drain (D) of the power transistor (18), via a first electrical link member (28), a second terminal of the battery (17) being linked electrically to the source (S) of the power transistor (18), via a second electrical link member (30), the first terminal of the module (12) being linked electrically to the first terminal of the battery (17) via a third electrical link member (32), the three link members (28, 30, 32) being linked mechanically to one another via an electrically insulating fitting (33).
